(19) Europäisches Patentamt
European Patent Office
Office européen des brevets

(11) EP 1 003 029 B1

(12) EUROPÄISCHE PATENTSCHRIFT

(45) Veröffentlichungstag und Bekanntmachung des Hinweises auf die Patenterteilung:
13.07.2005 Patentblatt 2005/28

(51) Int Cl.⁷: **G01N 23/04**, B81B 1/00

(21) Anmeldenummer: **99120512.1**

(22) Anmeldetag: **15.10.1999**

(54) **Röntgenanalysegerät mit röntgenoptischem Halbleiterbauelement und Verfahren zu dessen Herstellung**

X-ray analysis apparatus with x-ray semiconductor optics and method of its fabrication

Dispositif d'analyse à rayons x avec optique pour rayons x à semi-conducteurs et procédé de sa fabrication

(84) Benannte Vertragsstaaten:
AT BE CH CY DE DK ES FI FR GB GR IE IT LI LU MC NL PT SE

(30) Priorität: **17.11.1998 DE 19852955**

(43) Veröffentlichungstag der Anmeldung:
**24.05.2000 Patentblatt 2000/21**

(73) Patentinhaber: **Bruker AXS GmbH**
**76187 Karlsruhe (DE)**

(72) Erfinder:
• **Lehmann, Volker, Dr.**
**80689 München (DE)**
• **Golenhofen, Rainer**
**76275 Ettlingen (DE)**

(74) Vertreter: **Kohler Schmid Möbus**
**Patentanwälte**
**Ruppmannstrasse 27**
**70565 Stuttgart (DE)**

(56) Entgegenhaltungen:
WO-A-98/50604    US-A- 4 142 101
US-A- 4 974 249

• LEHMANN V: "THE PHYSICS OF MACROPORE FORMATION IN LOW DOPED N-TYPE SILICON" JOURNAL OF THE ELECTROCHEMICAL SOCIETY, ELECTROCHEMICAL SOCIETY. MANCHESTER, NEW HAMPSHIRE, US, Bd. 140, Nr. 10, 1. Oktober 1993 (1993-10-01), Seiten 2836-2843, XP000604663 ISSN: 0013-4651

**Beschreibung**

Die Erfindung betrifft ein Röntgenanalysegerät mit einer Röntgenquelle zur Beleuchtung einer Probe mit Röntgenstrahlung, einer Probenhalterung zur Aufnahme der Probe und einem Detektor zum Nachweis der von der Probe ausgehenden gebeugten oder gestreuten Röntgenstrahlung bzw. Röntgenfluoreszenzstrahlung, wobei im Strahlengang zwischen der Röntgenquelle und dem Detektor ein röntgenoptisches Bauelement aus Halbleitermaterial mit einer Vielzahl von für Röntgenstrahlung transparenten Mikroporen vorgesehen ist, wobei das röntgenoptische Bauelement einem Druckunterschied ausgesetzt ist und einen Halbleiterwafer umfaßt, in den in Strahlrichtung verlaufende Mikroporen mit Durchmessern von 0,1 bis 100 $\nu$m, vorzugsweise 0,5 bis 20 $\nu$m eingeätzt sind, wobei jeweils zwei Mikroporen in jedem Abstand zur Oberfläche des röntgenoptischen Bauelements gleich weit voneinander beabstandet sind.

Ein röntgenoptisches Bauelement mit den eingangs beschriebenen Merkmalen ist bekannt aus der US-A 4,933,557.

Röntgenoptische Bauteile im Strahlengang des Röntgenanalysegerätes können beispielsweise Röntgen-Fenster, Röntgen-Kollimatoren oder Röntgen-Linsen sein. Die Röntgen-Fenster müssen hinreichend transparent auch für weiche Röntgenstrahlung sein, so daß sie bisher entweder aus Elementen mit kleinem Z-Wert oder aber mit sehr geringer Dicke hergestellt werden. Fenster für Röntgenröhren (beispielsweise für Cu-k$\alpha$-Strahlung) werden bislang aus Beryllium gefertigt, was den großen Nachteil hat, daß derartige Röhren später als Sondermüll entsorgt werden müssen, da Beryllium hochgiftig ist. Als Alternative sind auch Röntgen-Fenster aus CVD-Diamantschichten untersucht worden, die jedoch in der Herstellung relativ teuer sind.

US-A-4,974,249 beschreibt ein Röntgenanalysegerät mit einem Multichannelplate mit einer Vielzahl von für die Röntgenstrahlung durchlässigen Kanälen, die einen Durchmesser zwischen 0,1 und 100 $\nu$m aufweisen, wobei das Microchannelplate im Strahlengang zwischen der Röntgenquelle und dem Detektor angeordnet ist. Aus WO 98 50604 A ist bekannt, derartige Microchannelplates aus einem Halbleiterwafer herzustellen. Derartige Microchannelplates sind jedoch nicht zur Verwendung in Apparaturen mit einer Druckdifferenz, beispielsweise als Vakuumabschluss, geeignet.

Im Röntgen-Detektor wiederum sind dünne organische Filme (beispielsweise Mylar, Polypropylen etc.) als Fensterschichten bekannt, jedoch müssen diese Röntgen-Fenster noch durch Gitterplättchen unterstützt werden, um dem Druck der äußeren Atmosphäre gegenüber dem üblicherweise evakuierten Röntgen-Detektor widerstehen zu können. Aus der US-A 5,416,821 ist beispielsweise bekannt, derartige Gitterplättchen aus anisotrop geätzten 110-Siliziumscheiben herzustellen, die auch kollimierende Eigenschaften haben, so daß das Bauteil die kombinierte Funktion eines Röntgen-Kollimatorfensters erhält.

Aufgabe der vorliegenden Erfindung ist es demgegenüber, ein Röntgenanalysegerät mit den eingangs beschriebenen Merkmalen vorzustellen, bei dem ein oder mehrere röntgenoptische Bauelemente eingesetzt sind, die einerseits ungiftig sind, andererseits für Röntgenstrahlung besonders transparent, wobei eine relativ hohe mechanische Festigkeit auch bei großen Öffnungsflächen und sehr kurzen Baulängen und damit eine besonders lange Lebensdauer sowie eine hohe Druckfestigkeit und Dichtigkeit erreicht werden soll.

Erfindungsgemäß wird diese komplexe Aufgabe auf überraschend einfache, aber wirkungsvolle Weise dadurch gelöst, daß die Mikroporen des röntgenoptischen Bauelements nicht durchgängig geformt sind.

Ein röntgenoptisches Bauelement aus einem derartigen Halbleiterwafer hat in seiner Verwendungsfunktion beispielsweise als Vakuumabschluß eine erheblich höhere Dichtigkeit als bisher verwendete Folien aus Kunststoff. Im Gegensatz zu Röntgen-Fenstern aus Beryllium ist ein derartiges Bauteil ungiftig und kann bei sehr hoher mechanischer Festigkeit beispielsweise durch Siliziumnitrid-Häutchen in der extrem geringen Dicke von 50 nm hergestellt werden, während Beryllium-Fenster üblicherweise eine Minimaldicke von 25 $\mu$m aufweisen. Wegen der Feinheit der Strukturen kann das erfindungsgemäße röntgenoptische Bauelement mit sehr kurzer Baulänge hergestellt werden, die im wesentlichen der Wafer-Dikke (100 bis 700 $\mu$m) entspricht, während beispielsweise bekannte Röntgen-Kollimatoren minimale Baudicken im Bereich mehrerer Zentimeter aufweisen. Selbstverständlich ist die geringe Baudicke des erfindungsgemäßen röntgenoptischen Bauelements auch in der Funktion als Röntgen-Fenster oder Röntgen-Linse von großem Vorteil, wobei keinerlei Konzessionen an die mechanische Festigkeit gemacht werden müssen.

Ein elektrochemisches Verfahren zur Herstellung von Mikroporen in Halbleiterwafern ist bekannt aus dem Artikel von V. Lehmann "The Physics of Micropore Formation in Low Doped n-Type Silicon", Journal of the Electrochemical Society, Vol. 140, No. 10, 2836-2843 (1993). Die in diesem Artikel als "Makroporen" bezeichneten Löcher mit Durchmessern in der Größenordnung 10$\mu$m werden dabei so geätzt, daß die Wände zwischen den entstehenden Poren sehr dünn (z.B. 2$\mu$m) sind und eine ebenfalls (in der Regel wenige $\mu$m) dünne Schicht von Silizium die jeweilige Porenspitze abschließt.

Bei einer bevorzugten Ausführungsform des erfindungsgemäßen Röntgenanalysegeräts bleibt eine Bodenfläche mit einer Dicke im Bereich von 1 bis 100 $\mu$m, vorzugsweise 5 bis 20 $\mu$m stehen. Dadurch ist die die effektive Siliziumschicht für das durchdringende Röntgenlicht äußerst dünn, wodurch eine hohe Transparenz des röntgenoptischen Bauteils erzielt wird. Das Gitter der Porenwände hingegen sorgt trotz der scheinbar geringen Wandstärke für eine relativ hohe mechanische Stabilität.

Bei einer bevorzugten Weiterbildung dieser Ausführungsform sind die Mikroporen auf ihrer Innenseite mit einer stabilisierenden Schicht ausgekleidet, die die Mikroporen an einer Seite des Halbleiterwafers abschließt. Dadurch kann die mechanische Stabilität des röntgenoptischen Bauelements noch weiter erhöht werden, ohne daß die Transparenz für Röntgenstrahlung wesentlich beeinträchtigt würde.

Um die Röntgentransparenz noch weiter zu erhöhen, wird bei einer besonders bevorzugten Weiterbildung die Bodenfläche des Halbleiterwafers an der Seite, an der die stabilisierende Schicht die Poren abschließt, bis zur stabilisierenden Schicht hin abgeätzt. Nach dieser selektiven Rückätzung des Wafermaterials bleibt nur noch ein ca. 20 bis 100 nm dünnes Häutchen der stabilisierenden Schicht übrig, das den Porenboden bedeckt und damit ein extrem dünnes Fenster für die Röntgenstrahlung generiert. Im Idealfall kann das erfindungsgemäße röntgenoptische Bauelement als Fenster für Röntgenfluoreszenz-Detektoren bis hin zu niedrigen Energien um 100 eV transparent sein.

Besonders bevorzugt wird die stabilisierende Schicht mittels CVD-Verfahren (= chemical vapor deposition) aufgebracht. Derartige CVD-Verfahren sind allgemein bekannt. Das Schichtmaterial wird dabei auf die zu belegende Fläche aufgebracht und gerät nach Abkühlung unter Kompression, wodurch eine Rißbildung verhindert wird.

Als Materialien für die stabilisierende Schicht werden bevorzugt Siliziumnitrid ($Si_3 N_4$), Bornitrid (BN), Borhydrid (BH) oder eventuell auch Borkarbid oder Siliziumkarbid oder auch Kohlenstoff eingesetzt. Damit lassen sich extrem dünne, den Porenboden bedeckende Häutchen erzeugen, die dennoch eine genügend hohe mechanische Festigkeit und Vakuumdichtigkeit in der Anwendung des erfindungsgemäßen röntgenoptischen Bauelements als Röntgen-Fenster aufweisen.

Besonders bevorzugt ist eine Ausführungsform des erfindungsgemäßen Röntgenanalysegeräts, bei der der Halbleiterwafer des röntgenoptischen Bauelements aus Silizium besteht. Für die mikrofeine Verarbeitung dieses Materials ist eine vielfältige und verbreitete Technologie aus dem Bereich der Herstellung elektronischer Bauteile wohlbekannt.

Der Halbleiterwafer des erfindungsgemäßen röntgenoptischen Bauelements wird in der Regel eine Dicke von $10 \mu m$ bis 1mm, vorzugsweise von 100 bis $700 \mu m$ aufweisen.

Mit den aus der Halbleitertechnik an sich bekannten Bearbeitungsverfahren lassen sich am einfachsten Mikroporen mit einem kreisförmigen Querschnitt herstellen. Bei Modifikation der bekannten Verfahren sind aber auch andere Querschnittsformen, beispielsweise elliptische Querschnitte herstellbar.

Im einfachsten Fall können die Mikroporen einen über die Porenlänge konstanten Querschnitt aufweisen. Für die meisten Anwendungsfälle wird diese Geometrie auch ausreichend sein.

Beispielsweise in der Anwendung des erfindungsgemäßen röntgenoptischen Bauelements als Röntgen-Linse kann es jedoch vorteilhaft sein, wenn die Mikroporen einen über die Porenlänge variablen Querschnitt aufweisen.

Besonders einfach ist eine Ausführungsform, bei der die Mikroporenachse i.w. senkrecht zur Oberfläche des Halbleiterwafers verläuft.

Alternativ sind aber auch Ausführungsformen denkbar, bei denen die Mikroporenachse schräg zur Oberfläche des Halbleiterwafers verläuft.

Bei einer weiteren Alternative verlaufen die Mikroporen in ihrer Durchgangsrichtung gekrümmt. Dies ist zwar von der Herstellung her um einiges aufwendiger als die beiden oben beschriebenen Alternativen, eröffnet dafür aber ein weites Feld von Anwendungsmöglichkeiten für das erfindungsgemäße röntgenoptische Bauelement.

So läßt sich damit bei einer bevorzugten Weiterbildung eine Röntgen-Linse herstellen, die in Durchgangsrichtung der Röntgenstrahlung wesentlich flacher ist als alle bisher bekannten derartigen röntgenoptischen Bauelemente.

Bei anderen bevorzugten Ausführungsformen übt das röntgenoptische Bauelement die Funktion eines Röntgen-Kollimators aus, der aufgrund des erfindungsgemäßen Aufbaus des Bauelements in Durchstrahlungsrichtung der Röntgenstrahlung besonders kurz gestaltet werden kann.

Bei weiteren besonders bevorzugten Ausführungsformen wird das röntgenoptische Bauelement in der Funktion eines Röntgen-Fensters im Röntgenanalysegerät eingesetzt. Hier ist die äußerst geringe minimale Dicke des erfindungsgemäßen röntgenoptischen Bauelements sowie seine sehr hohe mechanische Festigkeit auch bei großflächigen Öffnungen und seine hohe Dichtigkeit als Vakuumabschluß von besonderem Vorteil.

Besonders bevorzugt ist eine Weiterbildung der oben beschriebenen Ausführungsformen, bei der das röntgenoptische Bauelement unmittelbar vor dem Röntgen-Detektor positioniert ist und die kombinierte Funktion eines Kollimator-Fensters ausübt.

Dabei ist es von besonderem Vorteil, wenn das röntgenoptische Bauelement mit dem Röntgen-Detektor eine bauliche Einheit bildet.

In seiner Funktion als Röntgen-Fenster oder kombiniertes Kollimator-Fenster kann bei weiteren Ausführungsformen das röntgenoptische Bauelement auch eine bauliche Einheit mit der Röntgenquelle bilden.

Die oben beschriebenen Ausführungsformen können auch gemeinsam bei einem erfindungsgemäßen Röntgenanalysegerät eingesetzt werden.

Die besonders hohen Festigkeitseigenschaften des erfindungsgemäßen röntgenoptischen Bauelements werden bei einer bevorzugten Ausführungsform ausgenutzt, in welcher der Strahlengang teilweise durch einen evakuierten Raum verläuft, der durch das röntgenoptische Bauelement von einem nicht-evakuierten Raum abgetrennt ist.

Bei einer weiteren besonders bevorzugten Ausführungsform ist vorgesehen, daß jeweils mehrere Mikroporen des röntgenoptischen Bauelements durch Aufätzen des dazwischen befindlichen Wafermaterials zu Mikroschlitzen verbunden sind. Damit kann eine Kollimation und/oder Fokussierung der Röntgenstrahlung in einer ausgewählten Richtung erfolgen und es wird eine höhere Transmission durch das röntgenoptische Bauelement erreicht.

In den Rahmen der Erfindung fällt auch ein Verfahren zur Herstellung eines röntgenoptischen Bauelements zum Einsatz in einem Röntgenanalysegerät der oben beschriebenen Art, umfassend:

(a) Anlegen von Ätzkeimen auf der Vorderseite eines Halbleiterwafers an den für die Einätzung von Mikroporen vorgesehenen Stellen mittels alkalischer Ätzung nach einem lithographischen Standardverfahren;

(b) Herausätzen der Mikroporen aus der Vorderseite des Halbleiterwafers mittels wässriger Flußsäure (HF) unter Anlegen eines elektrischen Potentials im Bereich einiger Volt, wobei der Ätzstrom vorzugsweise durch Beleuchten der Rückseite des Halbleiterwafers generiert wird;

(c) Beschichtung des Halbleiterwafers mittels CVD-Verfahren, vorzugsweise mit $Si_3N_4$;

(d) Abätzen der Rückseite des Halbleiterwafers bis zur CVD-Schicht in den Spitzen der Mikroporen.

Prinzipiell ist es darüber hinaus denkbar, einen zusätzlichen Verfahrensschritt anzuschließen:

(e) Entfernen der CVD-Schicht, vorzugsweise mittels Flußsäure.

Die Beschichtung, die während der Herstellung des röntgenoptischen Bauelementes als mechanische Stütze diente, ist z.B. in der Funktion des Bauteils als Kollimator nicht mehr unbedingt erforderlich, so daß durch ihre Entfernung eine besonders hohe Transparenz für die Röntgenstrahlung erreicht wird. Für einen Einsatz als Röntgen-Fenster mit relativ hohen Differenzdrücken ist die mechanische Stabilität dann allerdings nicht mehr ausreichend.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung, wie sie durch die Patentansprüche definiert wird.

Die Erfindung ist in der Zeichnung dargestellt und wird anhand von Ausführungsbeispielen näher erläutert. Es zeigen:

Fig. 1      eine schematische räumliche Ansicht der Komponenten einer Ausführungsform des erfindungsgemäßen Röntgenanalysegeräts;

Fig. 2      schematische Schnittansicht durch den Halbleiterwafer einer Ausführungsform des röntgenoptischen Bauelements;

Fig. 3a     wie Fig. 2, aber mit stabilisierender Schicht auf der Innenseite der Mikroporen des Halbleiterwafers;

Fig. 3b     wie Fig. 3a, aber mit bis zur stabilisierenden Schicht abgeätzten Bodenfläche des Halbleiterwafers;

Fig. 4      eine schematische Draufsicht auf die Mikroporen eines Halbleiterwafers; und

Fig. 5      wie Fig. 4, aber mit zu Schlitzen verbundenen Mikroporen.

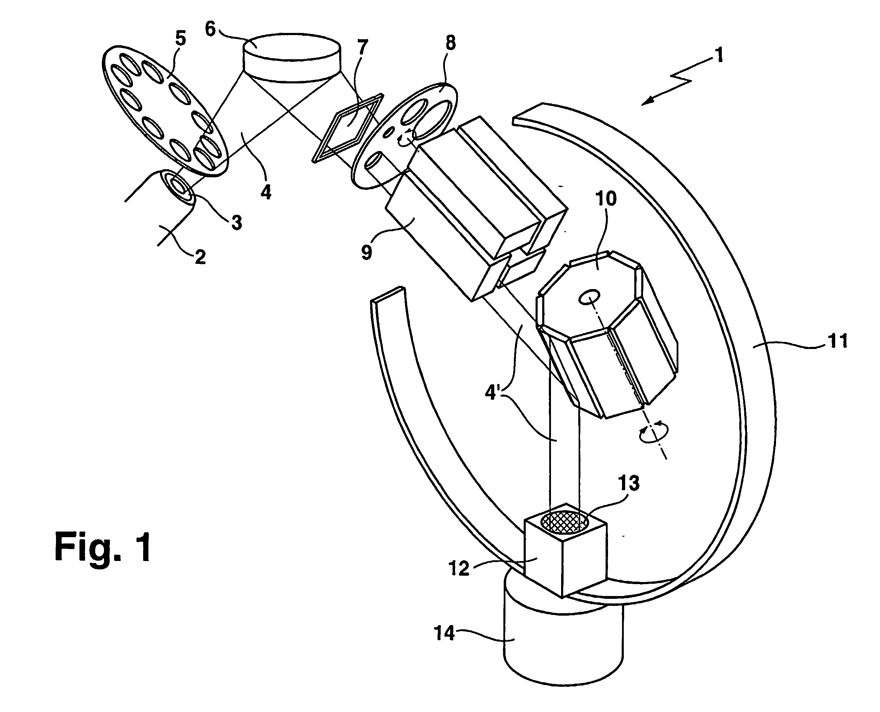

In Fig. 1 sind schematisch die Komponenten eines Röntgenanalysegeräts 1 in ihrer räumlichen Relation dargestellt. In einer Röntgenquelle 2 mit einem Röntgen-Fenster 3 wird Röntgenstrahlung 4 erzeugt, welche über eine Röntgen-Filteranordnung 5 zu einer Probe 6 gelangt, von wo gebeugte oder gestreute Röntgenstrahlung bzw. Röntgenfluoreszenzstrahlung 4' durch ein Fenster 7, gelangt, welches bei flüssigen Proben den mit Gas gefluteten Probenraum vom evakuierten Spektrometerraum trennt, und über eine zur Probengröße passende Kollimatorblende 8 in einen Röntgen-Kollimator 9, der bei dem in Fig. 1 dargestellten Ausführungsbeispiel aus vier einzelnen Kollimatoren aufgebaut ist, die je nach Bedarf durch Rotation der Kollimatoreinrichtung 9 in den Strahlengang der von der Probe 6 ausgehenden Röntgenstrahlung 4' eingebracht werden können.

Die aus dem Röntgen-Kollimator 9 austretende Röntgenstrahlung 4' wird an einer Analysatoreinheit 10 gebeugt, die im gezeigten Ausführungsbeispiel aus 8 verschiedenen, um den Umfang einer rotierbaren Trommel verteilten Analysatorkristallen besteht. Von da gelangt die Röntgenstrahlung 4' über einen Kollimator mit Eintrittsfenster 13 in einen auf einem Goniometer 11 montierten Röntgen-Detektor bestehend aus einem Proportionalflußzähler 12 und einem Szintillationszähler 14.

Bei dem erfindungsgemäßen Röntgenanalysegerät 1 ist in der Funktion als Röntgen-Fenster, Röntgen-Kollimator, kombiniertes Kollimatorfenster oder beispielsweise auch als Röntgen-Linse mindestens ein röntgenoptisches Bauelement eingesetzt, das einen Halbleiterwafer umfaßt, in den eine Vielzahl von in Strahlrichtung der Röntgenstrahlung 4, 4' verlaufende, parallele Mikroporen mit Durchmessern zwischen 0,1 und 100 ɤm eingeätzt sind. Der Halbleiterwafer wird in der Regel aus Silizium bestehen und eine Dicke zwischen 10 νm und 1 mm, vorzugsweise im Bereich von 100 bis 700 νm aufweisen.

Die Geometrie der Mikroporen im Halbleiterwafer des jeweiligen röntgenoptischen Bauelements kann je nach Funktion und Einsatzzweck variiert werden. Das erfindungsgemäße röntgenoptische Bauelement kann auch eine bauliche Einheit mit anderen Bauelementen des Röntgenanalysegeräts 1, beispielsweise einem Röntgen-Detektor wie etwa dem Proportionalflußzähler 12 oder in seiner Funktion als Röntgen-Fenster 3 eine Einheit mit der Röntgenröhre 2 bilden.

Der prinzipielle Aufbau des erfindungsgemäßen röntgenoptischen Bauelements ist anhand der Figuren,2 bis 5 dargestellt:

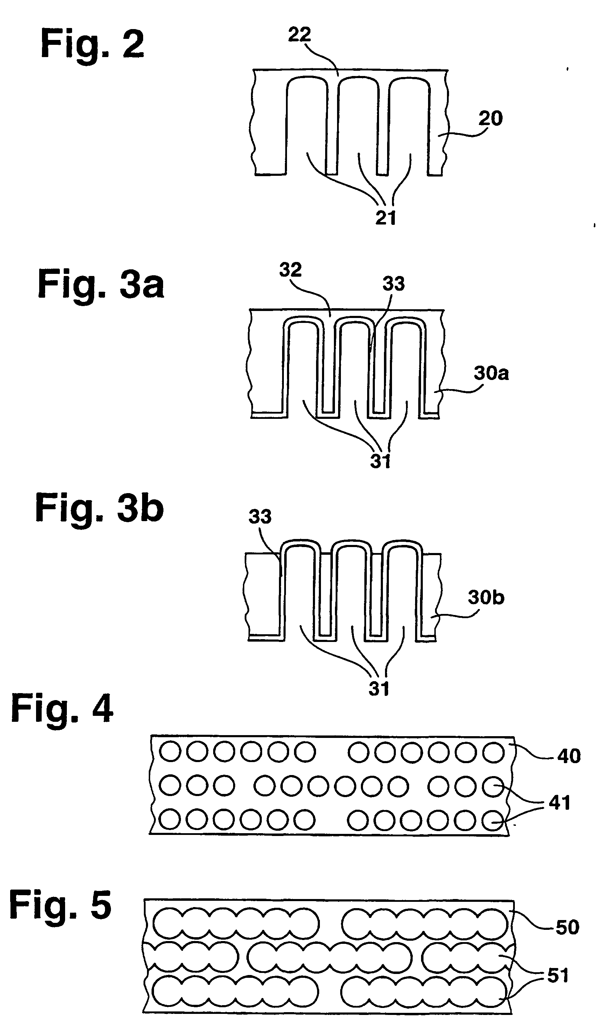

Fig. 2 zeigt einen Schnitt durch einen Halbleiterwafer 20, in welchen die oben beschriebenen Mikroporen 21 eingeätzt sind. Da die Mikroporen 21 nicht durchgängig durch den Halbleiterwafer 20 geätzt sind, bleibt eine stabilisierende Bodenfläche 22 mit einer Dicke im Bereich von etwa 5 bis 20 νm stehen. Die parallel verlaufenden Mikroporen 21 können beispielsweise eine Kollimationsfunktion für die Röntgenstrahlung 4, 4' übernehmen.

Um die Stabilität des röntgenoptischen Bauelements zu erhöhen, können die Mikroporen 31 des Halbleiterwafers 30a, wie in Fig. 3a dargestellt ist, mit einer stabilisierenden Schicht 33 ausgekleidet sein, die die Mikroporen 31 an der die Bodenfläche 32 tragenden Seite des Halbleiterwafers 30a abschließt. Die stabilisierende Schicht 33 kann beispielsweise mittels CVD-Verfahren (=chemical vapor deposition) aufgebracht sein. Als Materialien für die stabilisierende Schicht 33 eignen sich Siliziumnitrid, Siliziumkarbid, Bornitrid, Borhydrid, Borkarbid und/oder Kohlenstoff.

Wie in Fig. 3b dargestellt, kann die in Fig. 3a stehengebliebene Bodenfläche 32 weggeätzt werden, so daß die Enden der Poren 31 nur noch durch die stabilisierende Schicht 33 nach der einen Seite hin abgeschlossen werden. Der Halbleiterwafer 30b selbst hat dann durchgängige Mikroporen 31.

In Fig. 4 ist eine Draufsicht auf einen Halbleiterwafer 40 mit eingeätzten Mikroporen 41 gezeigt. Die Mikroporen 41 weisen in diesem Ausführungsbeispiel einen kreisförmigen Querschnitt auf und verlaufen in etwa senkrecht zur Oberfläche des Halbleiterwafers 40. In der Regel werden die Mikroporen 21, 31, 41, wie in den Figuren 2 bis 3b gezeigt, einen über die Porenlänge konstanten Querschnitt aufweisen.

Bei in der Zeichnung nicht dargestellten weiteren Ausführungsformen des röntgenoptischen Bauelements können die Mikroporen aber auch einen anderen als den kreisförmigen Querschnitt aufweisen, der auch über die Porenlänge variabel sein kann. Auch kann die Mikroporenachse schräg zur Oberfläche des jeweiligen Halbleiterwafers verlaufen oder die Mikroporen können in ihrer Durchgangsrichtung gekrümmt sein. Letzteres wäre beispielsweise vorteilhaft für die Funktion des entsprechenden röntgenoptischen Bauelements als Röntgen-Linse.

Eine weitere besondere Ausführungsform ist in Fig. 5 gezeigt, wo jeweils mehrere Mikroporen des Halbleiterwafers 50 durch Aufätzen des dazwischen befindlichen Wafermaterials zu Mikroschlitzen 51 verbunden sind. Damit läßt sich beispielsweise eine Kollimation bevorzugt in einer quer zum Strahlengang verlaufenden Richtung durchführen, während in der anderen Richtung, die der Längsausdehnung der Schlitze 51 entspricht, keine Kollimation stattfindet.

In der folgenden Tabelle ist eine Abschätzung der Transmission von Röntgenstrahlung 4, 4' in %-Anteilen ohne Berücksichtigung eines Stützgitters und ohne Bodenflächen 22, 32 angegeben, wobei einmal als Beschichtungsmaterial Bornitrid, zum anderen Siliziumnitrid angenommen wurde. In der letzten Spalte sind zum Vergleich die Transmissionswerte für eine Mylar-Folie angegeben:

| Element | kα(eV) | 50nm BN 1,9g/cm$^3$ | 50nm Si$_3$N$_4$ 3,1g/cm$^3$ | 1000nm C(Mylar Folie) 1,0g/cm$^3$ |
|---------|--------|---------------------|------------------------------|-----------------------------------|
| Be | 108,5 | 79% | 28% | 14,7% |
| B | 183,3 | 93% | 42% | 53% |
| C | 277 | 84% | 69% | 79% |
| N | 392,4 | 93% | 85% | 8% |
| O | 524,9 | 88% | 83% | 29% |

Diese Abschätzung zeigt, daß ein erheblicher Nachteil von Kunststofffenstern, nämlich niedrige Transmission für Stickstoff-Strahlung, bei den erfindungsgemäßen Röntgen-Fenstern nicht auftritt.

Die mechanische Festigkeit der nach dem Abätzen der Bodenfläche 32 an den Spitzen der Mikroporen 31 stehenbleibenden Häutchen aus Beschichtungsmaterial 33 läßt sich über den maximalen Differenzdruck p max, den die Anordnung aushalten kann, abschätzen:

$$p \text{ max} = 1{,}5 \ (d/r)^2 \text{sigma}$$

Mit d = 50nm, r = 1000nm und sigma = $1{,}4 \ 10^{11}$ dyne/cm$^2$ folgt p max = 518 atm.

Dies macht bei allen Unsicherheiten (es wurde sigma für den $Si_3N_4$ Einkristall genommen, die Formel streng gilt für plane Scheiben) deutlich, daß selbst wesentlich dünnere Beschichtungen einem Druck von einer Atmosphäre in ihrer Funktion als Röntgen-Fenster sicher standhalten können.

Versuche zur mechanischen Belastbarkeit und Optimierung der durch anisotrope Ätzung hergestellten Stützgitter haben dies bestätigt.

## Patentansprüche

1. Röntgenanalysegerät (1) mit einer Röntgenquelle (2) zur Beleuchtung einer Probe (6) mit Röntgenstrahlung (4), einer Probenhalterung zur Aufnahme der Probe (6) und einem Detektor (12, 14) zum Nachweis der von der Probe (6) ausgehenden gebeugten oder gestreuten Röntgenstrahlung bzw. Röntgenfluoreszenzstrahlung (4'), wobei im Strahlengang zwischen der Röntgenquelle (2) und dem Detektor (12, 14) ein röntgenoptisches Bauelement aus Halbleitermaterial mit einer Vielzahl von für Röntgenstrahlung transparente Mikroporen vorgesehen ist, wobei das röntgenoptische Bauelement einem Druckunterschied ausgesetzt ist und einen Halbleiterwafer (20; 30a; 30b; 40; 50) umfaßt, in den in Strahlrichtung verlaufende Mikroporen (21; 31; 41) mit Durchmessern von 0,1 bis 100 μm, vorzugsweise 0,5 bis 20 μm eingeätzt sind, wobei jeweils zwei Mikroporen in jedem Abstand zur Oberfläche des röntgenoptischen Bauelements gleich weit voneinander beabstandet sind, wobei die Mikroporen (21; 31; 41) nicht durchgängig geformt sind.

2. Röntgenanalysegerät nach Anspruch 1, **dadurch gekennzeichnet, daß** eine Bodenfläche (22; 32) mit einer Dicke im Bereich von 1 bis 100 μm, vorzugsweise 5 bis 20 μm stehen bleibt.

3. Röntgenanalysegerät nach Anspruch 2, **dadurch gekennzeichnet, daß** die Mikroporen (31) auf ihrer Innenseite mit einer stabilisierenden Schicht (33) ausgekleidet sind, die die Mikroporen (31) an einer Seite des Halbleiterwafers (30a; 30b) abschließt.

4. Röntgenanalysegerät nach Anspruch 3, **dadurch gekennzeichnet, daß** die stabilisierende Schicht (33) Siliziumnitrid, Siliziumkarbid, Bornitrid, Borhydrid, Borkarbid und/oder Kohlenstoff aufweist.

5. Röntgenanalysegerät nach einem der vorhergehenden Ansprüche, **dadurch gekennzeichnet, daß** der Halbleiterwafer (20; 30a; 30b; 40; 50) eine Dicke von 10 μm bis 1 mm, vorzugsweise von 100 bis 700 μm aufweist.

6. Röntgenanalysegerät nach einem der vorhergehenden Ansprüche, **dadurch gekennzeichnet, daß** das röntgenoptische Bauelement (13) unmittelbar vor dem Detektor (12) positioniert ist.

7. Röntgenanalysegerät nach Anspruch 6, **dadurch gekennzeichnet, daß** das röntgenoptische Bauelement (13) mit dem Detektor (12) eine bauliche Einheit bildet.

8. Röntgenanalysegerät nach einem der Ansprüche 1 bis 5, **dadurch gekennzeichnet, daß** das röntgenoptische Bauelement (3) mit der Röntgenquelle (2) eine bauliche Einheit bildet.

9. Röntgenanalysegerät nach einem der vorhergehenden Ansprüche, **dadurch gekennzeichnet, daß** der Strahlengang (4, 4')teilweise durch einen evakuierten Raum verläuft, welcher durch das röntgenoptische Bauelement (7) von einem nicht-evakuierten Raum abgetrennt ist.

10. Röntgenanalysegerät nach einem der vorhergehenden Ansprüche, **dadurch gekennzeichnet, daß** jeweils mehrere Mikroporen des röntgenoptischen Bauelements zu Mikroschlitzen (51) verbunden sind.

**11.** Verfahren zur Herstellung eines röntgenoptischen Bauelements gemäß einem der Ansprüche 1-10 zum Einsatz in einem Röntgenanalysegerät (1) **gekennzeichnet durch** folgende Verfahrensschritte:

(a) Anlegen von Ätzkeimen auf der Vorderseite eines Halbleiterwafers (20; 30a; 30b; 40; 50) an den für die Einätzung von Mikroporen (21; 31; 41) vorgesehenen Stellen mittels alkalischer Ätzung nach einem lithographischen Standardverfahren;

(b) Herausätzen der Mikroporen (21; 31; 41) aus der Vorderseite des Halbleiterwafers (20; 30a; 30b; 40; 50) mittels wässriger Flußsäure (HF) unter Anlegen eines elektrischen Potentials im Bereich einiger Volt, wobei der Ätzstrom vorzugsweise **durch** Beleuchten der Rückseite des Halbleiterwafers (20; 30a; 30b; 40; 50) generiert wird;

(c) Beschichtung des Halbleiterwafers (30a; 30b) mittels CVD-Verfahren, vorzugsweise mit $Si_3N_4$;

(d) Abätzen der Rückseite des Halbleiterwafers (30b) bis zur CVD-Schicht (33) in den Spitzen der Mikroporen (31).

**Claims**

**1.** X-ray analysis device (1) comprising an X-ray source (2) for illuminating a sample (6) with X-ray radiation (4), a sample holder for receiving the sample (6) and a detector (12, 14) for detecting the diffracted or scattered X-ray radiation or X-ray fluorescence radiation (4') emitted by the sample (6), wherein an X-ray optical component of semi-conducting material having a plurality of micropores which are transparent to X-ray radiation is provided in the optical path between the X-ray source (2) and the detector (12, 14), wherein the X-ray optical component is exposed to a pressure difference and comprises a semi-conductor wafer (20; 30a; 30b; 40; 50) having etched micropores (21; 31; 41) which have a diameter between 0.1 and 100μm, preferably between 0.5 and 20μm, and extend in the direction of the ray, wherein two micropores in each case have the same mutual distance at each separation from the surface of the X-ray optical component, wherein the micropores (21; 31; 41) are not continuously formed.

**2.** X-ray analysis device according to claim 1, **characterized in that** a bottom surface (22; 32) remains having a thickness in the range between 1 and 100μm, preferably between 5 and 20μm.

**3.** X-ray analysis device according to claim 2, **characterized in that** the inner side of the micropores (31) is lined with a stabilizing layer (33) which closes the micropores (31) on one side of the semi-conductor wafer (30a; 30b).

**4.** X-ray analysis device according to claim 3, **characterized in that** the stabilizing layer (33) comprises silicon nitride, silicon carbide, boron nitride, hydroboron, boron carbide and/or carbon.

**5.** X-ray analysis device according to any one of the preceding claims, **characterized in that** the semi-conductor wafer (20; 30a; 30b; 40; 50) has a thickness between 10μm and 1mm, preferably between 100 and 700μm.

**6.** X-ray analysis device according to any one of the preceding claims, **characterized in that** the X-ray optical component (13) is positioned directly in front of the detector (12).

**7.** X-ray analysis device according to claim 6, **characterized in that** the X-ray optical component (13) and the detector (12) form a structural unit.

**8.** X-ray analysis device according to any one of the claims 1 through 5, **characterized in that** the X-ray optical component (3) and the X-ray source (2) form a structural unit.

**9.** X-ray analysis device according to any one of the preceding claims, **characterized in that** the optical path (4; 4') extends partially through an evacuated room which is separated from a non-evacuated room by the X-ray optical component (7).

**10.** X-ray analysis device according to any one of the preceding claims, **characterized in that** several micropores of the X-ray optical component are connected to form micro slots (51).

**11.** Method for producing an X-ray optical component according to any one of the claims 1 through 10 for use in an X-ray analysis device (1), **characterized by** the following steps:

(a) applying etching seed onto the front side of a semi-conductor wafer (20; 30a; 30b; 40; 50) at the locations provided for etching micropores (21; 31; 41) using alkaline etching according to a lithographic standard method;
(b) etching the micropores (21; 31; 41) from the front side of the semi-conductor wafer (20; 30a; 30b; 40; 50) using aqueous hydrofluoric acid (HF) thereby applying an electric potential in the range of a couple of Volts, wherein the etching current is preferably generated by illumination of the rear side of the semi-conductor wafer (20; 30a; 30b; 40; 50);
(c) coating the semi-conductor wafer (30a; 30b) using CVD methods, preferably with $Si_3N_4$;
(d) etching the rear side of the semi-conductor wafer (30b) down to the CVD layer (33) in the bottom of the micropores (31).

**Revendications**

**1.** Appareil d'analyse aux rayons X (1) avec une source de rayons X (2) pour illuminer un échantillon (6) avec un rayonnement X (4), un porte-échantillon pour recevoir l'échantillon (6) et un détecteur (12, 14) pour déceler le rayonnement X ou le rayonnement X de fluorescence (4') diffracté ou dispersé provenant de l'échantillon (6), dans lequel il est prévu dans le trajet des rayons entre la source de rayons X (2) et le détecteur (12, 14) un composant optique à rayons X en matériau semiconducteur avec une pluralité de micropores transparents au rayonnement X, le composant optique à rayons X étant exposé à une différence de pression et comprenant une plaquette semiconductrice (20 ; 30a ; 30b ; 40 ; 50) dans laquelle sont gravés des micropores (21 ; 31 ; 41) s'étendant dans la direction des rayons, de diamètres allant de 0,1 à 100 µm, de préférence de 0,5 à 20 µm, chaque fois deux micropores à chaque distance par rapport à la surface du composant optique à rayons X étant éloignés l'un de l'autre de la même distance, les micropores (21 ; 31 ; 41) n'étant pas formés de manière traversante.

**2.** Appareil d'analyse aux rayons X selon la revendication 1, **caractérisé par le fait qu'**il reste une surface de fond (22 ; 32) d'une épaisseur se situant dans la fourchette de 1 à 100 µm, de préférence de 5 à 20 µm.

**3.** Appareil d'analyse aux rayons X selon la revendication 2, **caractérisé par le fait que** les micropores (31) sont revêtus sur leur côté intérieur d'une couche stabilisante (33) qui ferme les micropores (31) sur un côté de la plaquette semiconductrice (30a ; 30b).

**4.** Appareil d'analyse aux rayons X selon la revendication 3, **caractérisé par le fait que** la couche stabilisante (33) présente du nitrure de silicium, du carbure de silicium, du nitrure de bore, de l'hydrure de bore, du carbure de bore et/ou du carbone.

**5.** Appareil d'analyse aux rayons X selon l'une des revendications précédentes, **caractérisé par le fait que** la plaquette semiconductrice (20 ; 30a ; 30b ; 40 ; 50) présente une épaisseur de 10 µm à 1 mm, de préférence de 100 à 700 µm.

**6.** Appareil d'analyse aux rayons X selon l'une des revendications précédentes, **caractérisé par le fait que** le composant optique à rayons X (13) est positionné directement devant le détecteur (12).

**7.** Appareil d'analyse aux rayons X selon la revendication 6, **caractérisé par le fait que** le composant optique à rayons X (13) forme une unité structurale avec le détecteur (12).

**8.** Appareil d'analyse aux rayons X selon l'une des revendications 1 à 5, **caractérisé par le fait que** le composant optique à rayons X (13) forme une unité structurale avec la source de rayons X (2).

**9.** Appareil d'analyse aux rayons X selon l'une des revendications précédentes, **caractérisé par le fait que** le trajet des rayons (4, 4') passe partiellement à travers un volume mis sous vide qui est séparé par le composant optique à rayons X (13) d'un volume non mis sous vide.

**10.** Appareil d'analyse aux rayons X selon l'une des revendications précédentes, **caractérisé par le fait que** chaque fois plusieurs micropores du composant optique à rayons X sont connectés en microfentes (51).

11. Procédé pour fabriquer un composant optique à rayons X selon l'une des revendications 1 à 10 destiné à être utilisé dans un appareil d'analyse aux rayons X (1), **caractérisé par** les étapes de procédé suivantes :

(a) application de germes de gravure sur le recto d'une plaquette semiconductrice (20 ; 30a ; 30b ; 40 ; 50) aux endroits prévus pour la gravure de micropores (21 ; 31 ; 41) par gravure alcaline selon un procédé lithographique standard ;

(b) gravure des micropores (21 ; 31 ; 41) sur le recto de la plaquette semiconductrice (20 ; 30a ; 30b ; 40 ; 50) à l'acide fluorhydrique (HF) aqueux sous application d'un potentiel électrique de l'ordre de quelques volts, le courant de gravure étant généré de préférence par illumination du verso de la plaquette semiconductrice (20 ; 30a ; 30b ; 40 ; 50) ;

(c) revêtement de la plaquette semiconductrice (30a ; 30b) par procédé CVD, de préférence avec du $Si_3N_4$ ;

(d) gravure du verso de la plaquette semiconductrice (30b) jusqu'à la couche CVD (33) dans les pointes des micropores (31).

Fig. 1

**Fig. 2**

**Fig. 3a**

**Fig. 3b**

**Fig. 4**

**Fig. 5**